# EUROPEAN PATENT APPLICATION

(11) **EP 0 966 188 A2**
(43) Date of publication of application: **22.12.1999**
(21) Application number: 99250192.4
(22) Date of filing: 17.06.1999
(51) Int. Cl.: H05K 5/06, H05K 5/00

(54) **Housing suitable for outdoor-installation**

(30) Priority: 17.06.1998 JP 17031298
(71) Applicant: NEC CORPORATION, Tokyo (JP)
(72) Inventor: Hirando, Katsuya, c/o NEC Corporation, Minato-ku, Tokyo (JP)
(74) Representative: Patentanwälte Wenzel & Kalkoff

(57) **Abstract**

A housing 10 accommodating an apparatus 11 has as a portion of its walls a multiple-layer wall 20, which comprises two or more sheet-like members, e.g., an outer and an inner wall 21 and 22, having different linear expansion coefficients and normally in close planar contact with one another. When the temperature of the multiple-layer wall 20 is reduced to be lower than the condensation portion in accordance with an ambient temperature change, the outer wall 21 undergoes linear contraction to form an inner apace 20a between it and the inner wall 22, thus changing the factor of heat penetration through the multiple-layer wall 20 into and out of the housing.

## Description

### BACKGROUND OF THE INVENTION

The present invention relates to housings suitable for outdoor-installation, which are provided for radio transmitting/receiving antennas and also for such equipment as PHS radio base stations and installed outdoors while accommodating various units and apparatuses. More specifically, the present invention concerns an outdoor-installed housing, which has as at least a portion of its walls a multiple-layer wall comprising two or more sheet-like members provided in close contact with one another and capable of undergoing linear expansion and contraction with ambient temperature change and thus forming an inner space or inner spaces in the multiple-layer wall in accordance with an ambient temperature change, thus changing the factor of heat penetration into its inner space to prevent condensation on its inner wall surfaces while ensuring heat penetration into and out of it.

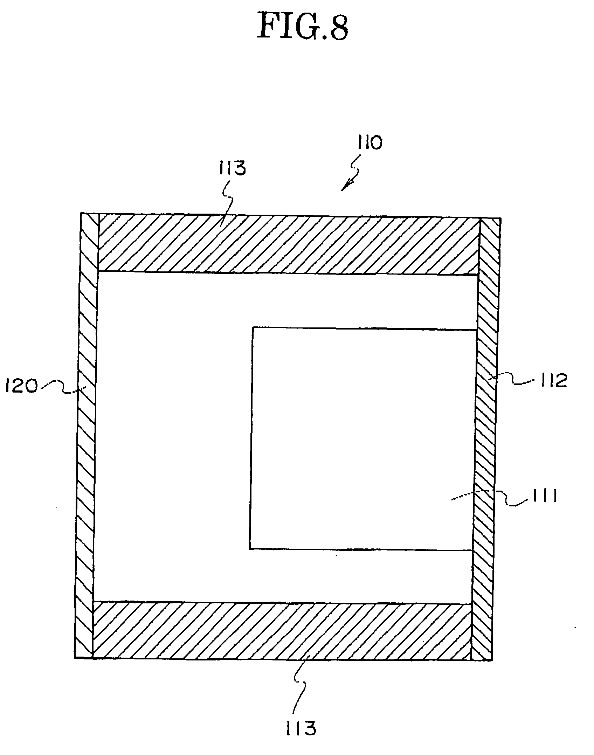

Radio transmitting/receiving antennas and also such equipment as PHS radio base stations usually use a hollow outdoor-installed housing, which is installed outdoors while accommodating various units and apparatuses. The outer walls of such an outdoor-installed housing have a heat-insulating water-proof structure for protecting the accommodated units and apparatuses from rainwater and ambient temperature changes, and also partly have a heat-radiating structure for effectively radiating heat generated in the accommodated units and apparatuses to the outside of the housing. Fig. 8 is a schematic sectional view showing such a prior art outdoor-installed housing.

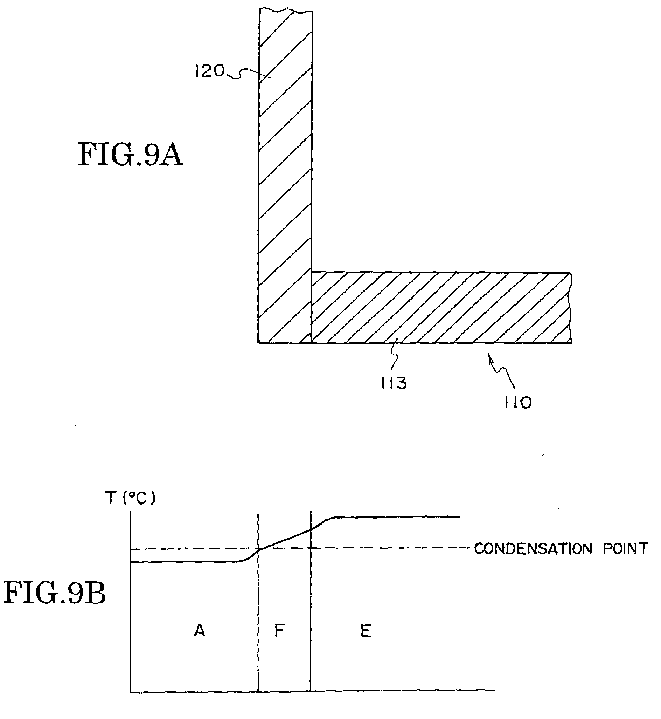

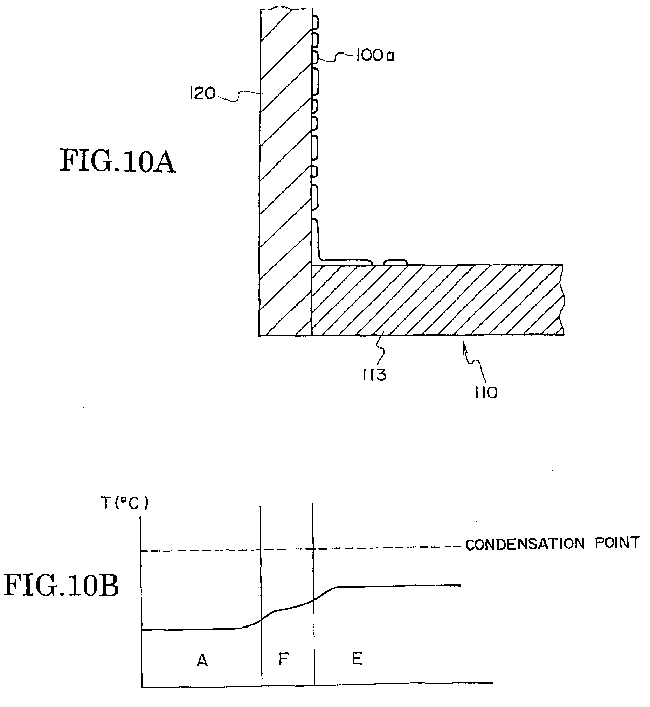

Figs. 9A and 9B are views for describing the state of the prior art outdoor-installed housing shown in Fig. 8 at the usual temperature, Fig. 9A being a fragmentary enlarged-scale sectional view showing the outdoor-installed housing, Fig. 9B being a view for describing the temperature gradient inside and outside the housing. Figs 10A and 10B are views for describing the state of the prior art outdoor-installed housing shown in Fig. 8 at a low temperature, Fig. 10A being a fragmentary enlarged-scale sectional view showing the outdoor-installed housing, Fig. 10B being a view for describing the temperature gradient inside and outside the housing.

As shown in these Figures, the hollow housing 110, which can accommodate various communication units and apparatuses, is used as an outdoor-installed housing for an antenna system or the like.

As shown in Fig. 8, the rear wall of the housing 110 is a heat radiator 112 in contact with an accommodated apparatus 111, and heat generated therein is directly radiated through the heat radiator 112 to the outside of the housing 110. The opposite sidewalls of the housing 110 are heat-insulating walls 113, through which no heat is penetrated into or out of the housing. The front wall of the housing 110 is a heat-radiating wall 120, through which heat is penetrated into and out of the housing. The heat-radiating wall 120 is not in direct contact with the apparatus 111 in the housing 110. However, the wall 120 is made of a heat conductor capable of permitting heat penetration of air heated by the apparatus 111 in the housing 110 through it to the outside of the housing 110. Gas-tight members such as packing or sealing members are provided between bonded portions of the heat-radiating wall 112, the heat-insulating walls 113 and the heat-radiating wall 120 of the housing 110 to have the interior thereof be gas-tight (or psuedo-gas-tight).

When the housing 110 having the prior art internally gas-tight (or psuedo gas-tight) structure is used as the outdoor-installed housing, the accommodated apparatus 111 is protected from outdoor rainwater and can provide its function. In addition, heat generated in the apparatus 111 is radiated either directly through the rear heat-radiator 112 or indirectly through the front heat-radiating wall 120, and the housing 110 and the apparatus 111 are thus not excessively heated.

This outdoor-installed housing, as shown in Figs. 9A, 9B, 10A and 10B, is subject to condensation on the inner wall surface of the front heat-radiating wall 120, through which heat is penetrated into and out of the housing, when the heat-radiating wall 120 is cooled down to be below the condensing point as a result of, for instance, a sudden reduction of the temperature outside the housing. When the outside of the housing is at normal temperature and also when it is reduced in temperature down to a level as shown at A in Fig. 9B, the inner wail surface of the heat-radiating wall 120 is at a temperature above the condensing point so long as the inner space (shown at E in Fig. 9B) on the inner side of the heat-radiating wall 120 (shown at F in Fig. 9B) of the housing 110 is held at a sufficiently high temperature. In this case, no condensation is brought about on the inner surface of the heat-radiating wall 120 (see Fig. 9A).

However, as shown in Fig. 10B, when the temperature of the outside of the housing (shown at A in Fig. 10B) is suddenly reduced, the temperature of the inner space (shown at E in Fig. 10B) on the inner side of the heat-radiating wall 120 (shown at F in Fig. 10B) of the housing 110 is also reduced because the heat penetration factor of the heat-radiating wall 120 is fixed. In this case, when the temperature of the inner surface of the heat-radiating wall 120 becomes lower than the condensing point, air in the housing cooled down by the heat-radiating wall 120 and liquified. Thus, condensation is brought about on the inner surface of the heat-radiating wall 120, thus generating water droplets 100a as shown in Fig. 10A. The heat-radiator 112, which the apparatus 111 is in direct contact with, and also the heat-insulating walls 113, through which no heat is penetrated into or out of the housing, are not cooled as a result of a sudden ambient temperature change, and no condensation is brought about on the inner surfaces of the heat radiator 112 and the heat-insulating walls 113.

When condensation is brought about in the housing 110 via the heat radiator 120 in this way, resultant water droplets 100a may cause metal corrosion of the inner walls of the housing 110 and the accommodated apparatus 111 and lead to a trouble in or damage to the system as a whole including the housing 110.

As a measure against the condensation in the conventional outdoor-installed housing, the heat capacity of the whole housing 110 is increased to prevent the temperature of the inner surface of the heat-radiating wall 120 from being reduced to be below the condensing point, or a water absorption material such as silica gel is provided in the housing 110 for absorbing water droplets generated as a result of condensation.

However, these measures against condensation in the prior art outdoor housing raises problems. Increasing the heat capacity of the whole housing leads to an increase of the weight of the whole system and also to an increase of the size of the housing itself.

Such system and housing increased in weight and size, lead to increased cost of manufacture. Besides, the operation of the outdoor installation of the housing is a great burden. Particularly, installation of the housing in a high level locality or in a narrow space dictates extreme difficulty. Such a housing, therefore, can not meet recent strong demands for smaller size and lighter weight outdoor-installed housings.

The case of using a water absorption material such as silica gel as a measure for preventing the condensation, is relatively free from the problem of the housing size increase. In this case, however, it is necessary to periodically replace the water absorption material, thus complicating the maintenance operation. Particularly, in the case of a system requiring opening and closing the housing after the installation thereof, the deterioration of the water absorption material proceeds whenever the housing is opened, thus leading to more cumbersome maintenance of the water absorption material.

In the conventional outdoor-installed housing having a heat-radiating wall for heat penetration into and out of inner space, in addition to the problem of the condensation, another problem is encountered in the case of, for instance, a sudden increase in the temperature outside the housing. In this case, the temperature inside the housing may be suddenly increased through the heat-radiating wall, resulting in excessive heating of the housing and the apparatus accommodated therein.

For the purpose of preventing or suppressing the condensation inside the outdoor-installed housing, Japanese Patent Laid-Open No. 59-89499 proposes an "Electric Apparatus Accommodation Housing", the walls of which have a double-wall structure such as to let condensation occur on the outer wall of the double-wall structure and not on the inner wall thereof.

In such a double-wall structure housing, however, the space is present around its entire inner walls. Therefore, no heat penetration into and out of the housing is obtainable, and thus heat generated in the accommodated apparatus can not be radiated to the outside of the housing.

It is actually difficult to use such a housing incapable of heat radiation to the outside as an outdoor-installed housing for accommodating an antenna or other radio communication units including a heat generator, which greatly generates heat and is to be accommodated.

### SUMMARY OF THE INVENTION

The present invention seeks to solve the above problems inherent in the prior art, and its object is to provide an outdoor-installed housing, which has as at least a portion of its walls a multiple-layer wall comprising two or more sheet-like members provided in close contact with one another and capable of undergoing linear expansion and contraction with ambient temperature change and thus forming an inner space or inner spaces in the multiple-layer wall in accordance with an ambient temperature change, thus changing the factor of heat penetration into its inner space to prevent condensation on its inner wall surfaces while ensuring heat penetration into and out of it.

According to one aspect of the present invention, there is provided an outdoor-installed housing which is hollow, capable of accommodating an apparatus in its inside and installed outdoors, and in which: at least a portion of its walls is constituted by a multiple-layer wall comprising two or more sheet-like members normally in close planar contact with one another; and in accordance with an ambient temperature change an inner space or inner spaces is formed between adjacent ones of the two or more sheet-like members of the multiple-layer wall, thus changing the factor of heat penetration through the multiple-layer wall.

According to another aspect of the present invention, there is provided an outdoor-installed housing which is hollow, capable of accommodating an apparatus in its inside and installed outdoors, and in which: at least a portion of its walls is constituted by a multiple-layer wall comprising two or more sheet-like members having different linear expansion coefficients and provided in close planar contact with one another; and in accordance with an ambient temperature change an inner space or inner spaces is formed between adjacent ones of the two or more sheet-like members of the multiple-layer wall, thus changing the factor of heat penetration through the multiple-layer wall.

When the temperature of the multiple-layer wall is reduced to be lower than the condensation point with a change in temperature around the multiple-layer wall, at least one of the two or more sheet-like members undergoes contraction to form an inner space adjacent to it. When the temperature of the multiple-layer wall is increased in accordance with a change in temperature around the multiple-layer wall, at least one of the two or more sheet-like members undergoes expansion to form an inner space adjacent to it. At least a portion of the walls of the housing excluding the multiple-layer wall is constituted by a heat-insulating wall. At least a portion of the walls of the housing excluding the multiple-layer wall is constituted by a heat radiator of an apparatus accommodated in the housing.

According to yet another aspect of the present invention, there is provided a housing having hollow portion in which an apparatus is accommodated wherein a multiple-layer wall is provided at a portion of the housing, the multiple-layer wall including two or more sheet-like members having the different linear expansion coefficients and provided in close planar contact with one another such that in accordance with an ambient temperature change an inner space or inner spaces is formed between adjacent ones of the two or more sheet-like members of the multiple-layer wall.

Two or three of the sheet-like members are provided. At least a portion of the walls of the housing excluding the multiple-layer wall is constituted by a heat-insulating wall. At least a portion of the walls of the housing excluding the multiple-layer wall is constituted by a heat radiator of the apparatus accommodated in the housing. The multiple-layer wall is provided on a side portion receiving sunlight of the housing. The formed inner space or inner spaces communicate with the inside of the housing.

With this housing or outdoor-installed housing having the above structure according to the present invention, the multiple-layer wall which is provided as a portion of the housing walls and comprises a plurality of sheet-like members normally held in close contact with one another and capable of undergoing linear expansion and contraction with ambient temperature changes, can form an inner space or inner spaces therein, thus changing the factor of heat penetration into and out of the housing in accordance with an ambient temperature change. Thus, while permitting heat penetration into and out of the housing to be obtained efficiently at normal temperature, when the temperature of the housing outside is suddenly reduced or increased, an inner space or inner spaces are formed in the multiple-layer wall to reduce the heat penetration factor and thus prevent condensation from occurring on the housing inner wall surfaces or suppress a sudden temperature rise of the housing or apparatus accommodated therein.

Therefore, with the outdoor-installed housing no water droplets are generated by condensation inside the housing, and it is thus possible to eliminate corrosion of metals inside the housing. In addition, such special means as a temperature controller or a water absorption material such as silica gel as used in the prior art housing are unnecessary, and it is possible to reduce the size and weight of the housing. It is thus possible to perfectly eliminate troubles or replacement operation of temperature control means or anti-condensation means and realize a maintenance-free outdoor-installed housing or housing.

Other objects and features will be clarified from the following description with reference to attached drawings.

### BRIEF DESCRIPTION OF THE DRAWINGS

Fig. 1 is a schematic sectional view showing the first embodiment of the outdoor-installed housing or housing according to the present invention in a state that normal temperature prevails around a multiple-layer wall;
Fig. 2 is a view similar to Fig. 1 but showing the housing in a state at a reduced temperature;
Figs. 3A and 3B are views for describing the embodiment of the outdoor-installed housing in a state at normal temperature as shown in Fig. 1;
Figs. 4A and 4B are views for describing the embodiment of the outdoor-installed housing in a state at a reduced temperature as shown in Fig. 2;
Figs. 5A and 5B are schematic fragmentary enlarged-scale sectional views showing a modification of the embodiment of the outdoor-installed housing;
Fig. 6 is a schematic elevational sectional view showing the second embodiment of the outdoor-installed housing according to the present invention in a state when normal temperature prevails around the multiple-layer wall;
Figs. 7A and 7B are fragmentary enlarged-scale sectional views showing the second embodiment of the outdoor-installed housing shown in Fig. 6 according to the present invention;
Fig. 8 is a schematic sectional view shoving such a prior art outdoor-installed housing;
Figs. 9A and 9B are views for describing the state of the prior art outdoor-installed housing shown in Fig. 8 at the usual temperature; and
Figs 10A and 10B are views for describing the state of the prior art outdoor-installed housing shown in Fig. 8 at a low temperature.

### PREFERRED EMBODIMENTS OF THE INVENTION

Preferred embodiments of the present invention will now be described with reference to the drawings.

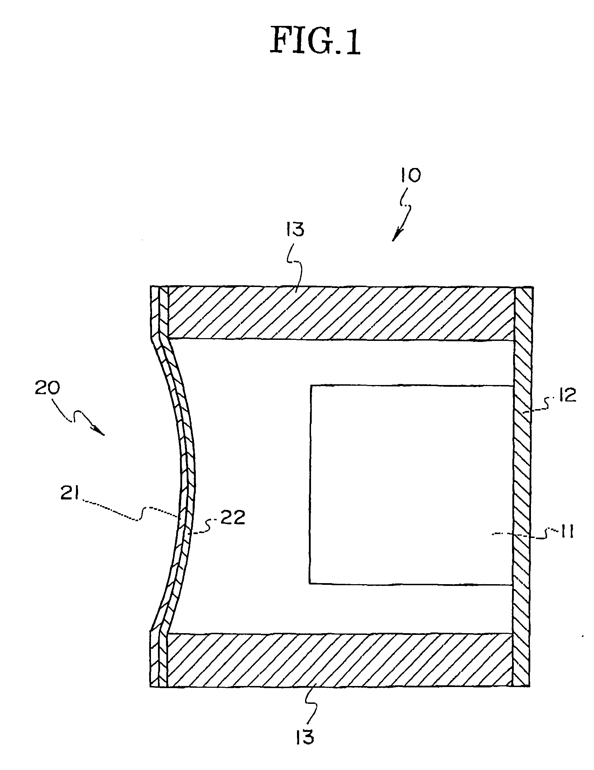

A first embodiment of the outdoor-installed housing or housing according to the present invention will now be described with reference to Figs. 1 to 5.

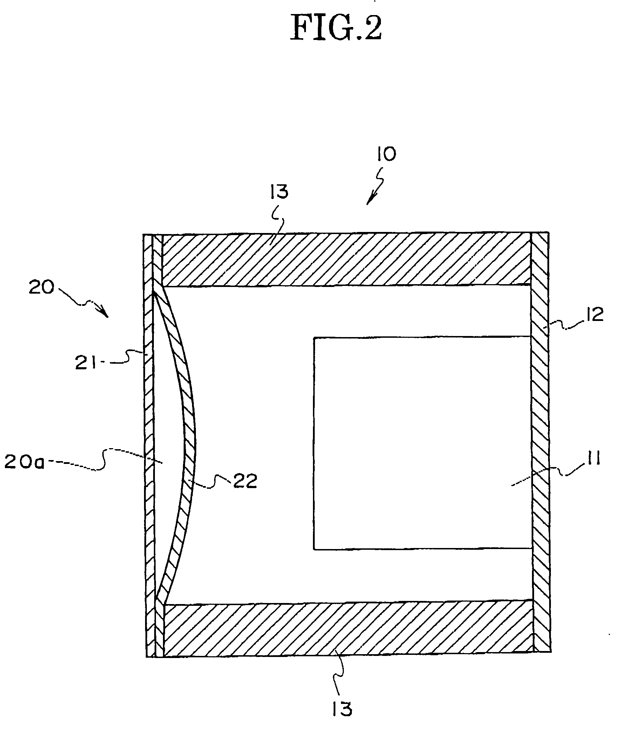

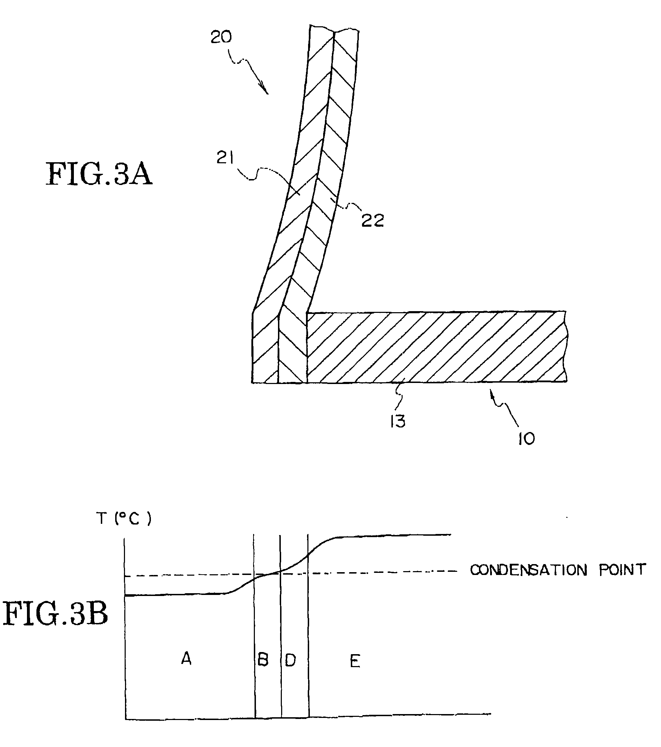

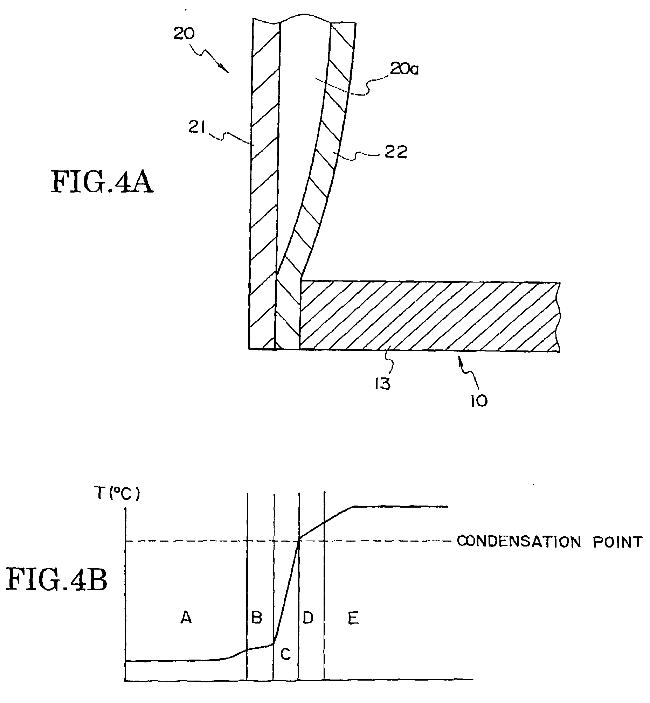

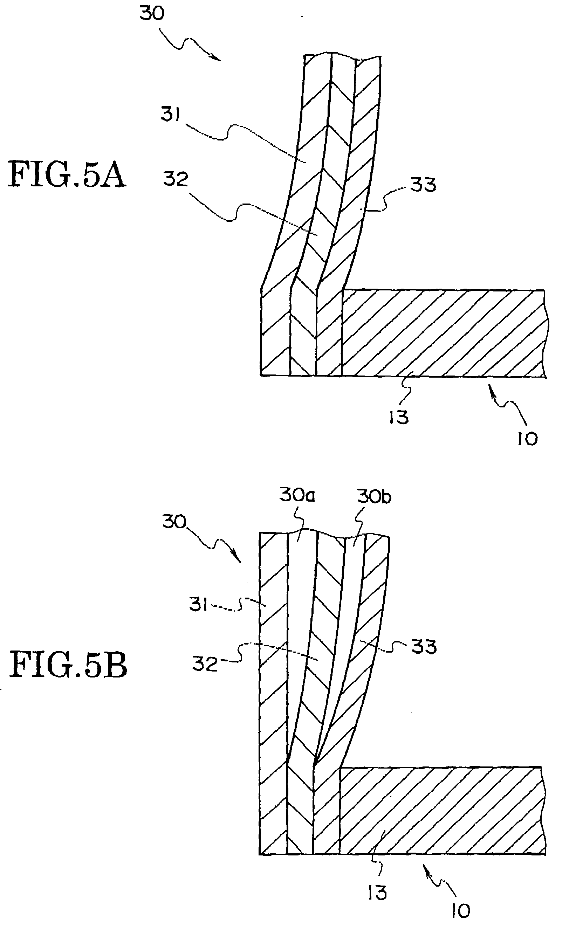

Fig. 1 is a schematic sectional view showing the first embodiment of the outdoor-installed housing according to the present invention in a state that normal temperature prevails around a multiple-layer wall. Fig. 2 is a view similar to Fig. 1 but showing the housing in a state at a reduced temperature. Figs. 3A and 3B are views for describing the embodiment of the outdoor-installed housing in a state at normal temperature as shown in Fig. 1, Fig. 3A being a fragmentary enlarged-scale section view showing the outdoor-installed housing, Fig. 3B being a graph showing a temperature gradient inside and outside the housing. Figs. 4A and 4B are views for describing the embodiment of the outdoor-installed housing in a state at a reduced temperature as shown in Fig. 2, Fig. 4A being a fragmentary enlarged-scale sectional view showing the outdoor-installed housing, Fig. 4B being a graph showing a temperature gradient inside and outside the housing. Figs. 5A and 5B are schematic fragmentary enlarged-scale sectional views showing a modification of the embodiment of the outdoor-installed housing, Fig. 5A showing the housing when normal temperature prevails around the multiple-layer wall, Fig. 5B showing the housing when a reduced temperature prevails.

As shown in these Figures, the embodiment of the outdoor-installed housing 10 is used as an outdoor-installed housing for an antenna unit or the like. The housing 10 is hollow and can accommodate an apparatus 11 constituting various communication units or the like, and it is installed outdoors.

At least a portion of the walls of the housing 10 is constituted by a multiple-layer wall 20 comprising two or more sheet-like members normally in close planar contact with one another. An inner space or inner spaces are formed in the multiple-layer wall 20 in accordance with an ambient temperature change, thus changing the factor of heat penetration through the multiple-layer wall 10 into and out of the housing 10 and preventing condensation therein.

Specifically, as shown in Figs. 1 and 2, the rear wall of the housing 10 is a heat radiator 12 in contact with the apparatus 11 accommodated in the housing. Heat generated in the apparatus 11 is directly radiated through the heat radiator 12 to the outside of the housing. The opposite side walls of the housing 10 are heat-insulating walls 13, through which no heat penetrates into or out of the housing.

As shown in Figs. 1 and 2, the front wall of the housing 10 is constituted by the multiple-layer wall 20, which comprises two sheet-like members (i.e.., an outer and an inner wall 21 and 22). The two sheet-like members, i.e., the outer and inner walls 21 and 22 of heat conductive member capable of air penetration into or out of the housing, of the multiple-layer wall 20 are normally in close planar contact with each other, and air in the housing, having been heated by heat generation in the apparatus 11, radiates through the multiple-layer wall 20 to the outside of the housing 10.

The factor of heat penetration through the multiple-layer wall 20 can be set as desired by appropriately selecting the heat conductivities and the contact thermal resistances of the outer and inner walls 21 and 22. Gas-tight structure members such as packing or sealing (not shown) are provided between bonded portions of the walls of the housing 10 including the multiple-layer wall 20, i.e., the heat radiator 12, the heat-insulating walls 13 and the multiple-layer wall 20.

The outer and inner walls 21 and 22 of the multiple-layer wall 20 in this embodiment are constituted by sheet-like members having different linear expansion coefficients. In this embodiment, the outer wall 21 is greater in the linear expansion coefficient than the inner wall 22. As shown in Fig. 1, at normal temperature the outer and inner walls 21 and 22 protrude into the housing in close planer contact with each other. In this state, the edges are secured to the heat-insulating walls 13 as the side walls of the housing. In accordance with an ambient temperature change the outer and inner walls 21 and 22 of the multiple-layer wall 20 undergo expansion or contraction with different linear expansion coefficients, thus forming an inner space 20a between them as shown in Fig. 2.

Specifically, this embodiment aims at preventing condensation inside the housing 10, and the linear expansion coefficients of the outer and inner walls 21 and 22 are set with respect to the condensation point inside the housing 10 as a reference. More specifically, the outer wall 21 made form a member having a sufficiently large linear expansion coefficient compared to the inner wall 22 such that it has a curved shape. When the temperature of the multiple-layer wall 20 is reduced to be below the condensation point due to, for instance, a sudden reduction of the temperature outside the housing 10, the outer wall 21 undergoes linear contraction to a shape like a flat sheet.

The inner wall 22 is made from a member having a smaller linear expansion coefficient than the outer wall 21 and not undergoing linear contraction when the temperature of the multiple-layer w0all 20 is reduced to be lower than the condensation point such that it has a curved shape. In order that air will flow into the inner space 20a formed due to linear contraction of the outer wall 21, edge portions of the inner wall 22 have gaps or holes communicating with the housing inner space. The outer and inner wails 21 and 22 have a curved shape protruding into the housing in a close planar contact with each other at normal temperature, and the edge portions are secured to the housing side.

With a temperature fail of the multiple-layer wall 20 past the condensation point with an ambient temperature change, the outer wall 21 undergoes linear contraction to change its shape such that it is pulled toward its edges to a shape like a flat sheet. The inner wall 22 which has been in planar contact with the outer wall 21 before the shape change thereof to the shape like flat sheet, does not undergo contraction shape change with the ambient temperature change, thus forming the inner space 20a between it and the outer wall 21.

As shown, when the multiple-layer wall 20 of the embodiment is cooled down to a temperature below the condensation point with a change in the temperature of the outside of the housing, the inner space 20a is formed between the outer and inner walls 21 and 22 due to linear contraction of the outer wall 21. With the formation of the inner space 20a the factor of heat penetration through the multiple-layer wall 20 into and out of the housing is reduced. Thus, irrespective of the outside temperature reduction the inner wall 22 of the multiple-layer wall 20 is not cooled down to be below the condensation point, and no condensation occurs inside the housing 10.

The outer and inner walls 21 and 22 constituting the multiple-wall wall 20 may be made of any members having different linear expansion coefficients and capable of forming the inner space 20a with a temperature change.

The operation of the embodiment of the outdoor-installed housing having the above construction will now be described with reference to Figs. 3 and 4.

Under usual conditions, the temperature of air inside the housing 10 is normally higher than the outside atmosphere temperature. In this state, the outer and inner walls 21 and 22 of the multiple-layer will 20 are in close contact with each other as shown in Fig. 3 In this state in which the housing outside is at normal temperature, no condensation occurs on the inner wall surfaces of the housing 10. Also, since the outer and inner walls 21 and 22 of the multiple-layer wall 20 are in close contact with each other, heat penetrates through the multiple-layer wall 20 into and out of the housing. Thus, heat generated in the apparatus 11 efficiently radiates to the outside of the housing. In addition to the case when the housing outside is at normal temperature, in the case when the housing outside (A in Fig. 3B) is reduced as shown in Fig. 3B, so long as the housing inside (E in Fig. 3B) on the inner side of the outer and inner walls 21 and 22 (B and D in Fig. 3B of the multiple-layer wall 20 is held at a high temperature by heat generated in, for instance, the apparatus 11, no condensation occurs on the inner surface of the inner wall 22 (refer to Fig. 3A).

With a sudden reduction of the temperature of the housing outside (A in Fig. 4B) as shown in Fig. 4B due to an external wind velocity increase or a weather change such as a rainfall, the outer wall 21 (B in Fig. 4C of the multiple-layer wall 20 is cooled down, so that its temperature is reduced to be lower than the condensation point. Since the outer wall 21 has a greater linear expansion coefficient, with its temperature tall to be lower than the condensation point, it undergoes linear contraction, and its curved portion protruding into the housing is pulled toward the edges to change its shape to be just like a flat sheet. On the other hand, the inner wall 22 which is smaller in the linear expansion coefficient than the outer wall 21, does not undergo linear contraction, and retains its original curved shape. Consequently, the inner space 20a is formed between the outer and inner walls 21 and 22, and air is supplied to the inner space 20a from the housing inner space side through the edges or the like of the inner wall 22.

With the inner space 20a thus formed in the multiple-layer wall 20, the factor of heat penetration through the multiple-layer wall 20 is reduced by the inner space 20a, which is filled with air having a low thermal conductivity. Thus, when the temperature of the outer wall 21 is reduced to be lower than the condensation point due to a sudden housing outside temperature fall, the temperature of the inner wall 22 is not reduced. Thus, as shown in Fig. 4B, the temperature of the inner wall 22 does not become lower than the condensation point, and no condensation occurs on the inner surface of the inner wall 22 facing the housing inside.

Even when the housing outside temperature is suddenly reduced, no condensation occurs on inner surfaces of the heat radiator 12 in direct contact with the apparatus 11 and the heat-insulating walls 13, through which no heat penetrates into and out of the housing, since the heat radiator 12 and the heat-insulating walls 23 are not cooled down irrespective of an ambient temperature change. When the ambient temperature is restored, the outer wall 21 having been changed in shape to be like a flat sheet due to cooling down to be lower than the condensation point undergoes linear expansion to restore the original curved shape and be in close contact with the inner wall 22 as shown in Fig. 1.

As has been shown above, the embodiment of the outdoor-installed housing 10 has as a portion of its walls the multiple-layer wall 20 comprising a combination of two sheet-like members, i.e., the outer wall 21 capable of undergoing linear contraction with an ambient temperature fall and the inner wall 22 incapable of undergoing linear contraction, in accordance with a housing outside temperature fall the inner space 20a can be formed in the multiple-layer wall 20 to reduce the factor of heat penetration into the housing 10. Thus, while permitting efficient heat penetration into and out of the housing at normal temperature, in the case of a sudden housing outside temperature fall it is possible to prevent condensation on the inner wall surfaces of the housing 10. Consequently, with this embodiment of the outdoor-installed housing no water droplets are formed due to condensation inside the housing 10, and it is possible to eliminate corrosion of metals inside the housing. Also, such special means as a temperature controller or a water absorption material such as silica gel as used in the prior art housing are unnecessary, and it is possible to reduce the size and weight of the housing 10. It is thus possible to effectively eliminate troubles or replacement operation for temperature control means or anti-condensation means and realize a maintenance-free outdoor-installed housing.

In the above embodiment, the multiple-layer wall 20 comprises two sheet-like members having different linear expansion coefficients, i.e., the outer and inner walls 21 and 22. However, this is by no means limitative. For example, as shown in Figs. 5A and 5B, it is possible to adopt a multiple-layer wall 30 comprising three sheet-like member having different linear expansion coefficients, i.e., an outer, an intermediate and an inner walls 31 to 33. In this case, a plurality of inner spaces 30a and 30b can be formed to change the heat penetration factor with increased versatility in accordance with changes in the housing outside temperature.

It is thus possible to use any multiple-layer wall, which is capable of being penetrated by heat and comprises a combination of two or more sheet-like members having different linear expansion coefficients.

The above embodiment has been described in connection with the formation of the inner space 20a in the multiple-layer wall 20 with linear contraction of the outer wall 21 when the temperature of the outside of the housing 10 is reduced. However, the inner space 20a may also be formed with liner expansion of the inner wall 22 caused in accordance with a temperature rise inside the housing 10. The multiple-layer wall 20 may thus be of any form so long as the inner space 20a is formed according to an ambient temperature change.

A second embodiment of the outdoor-installed housing according to the present invention will now be described with reference to the drawings.

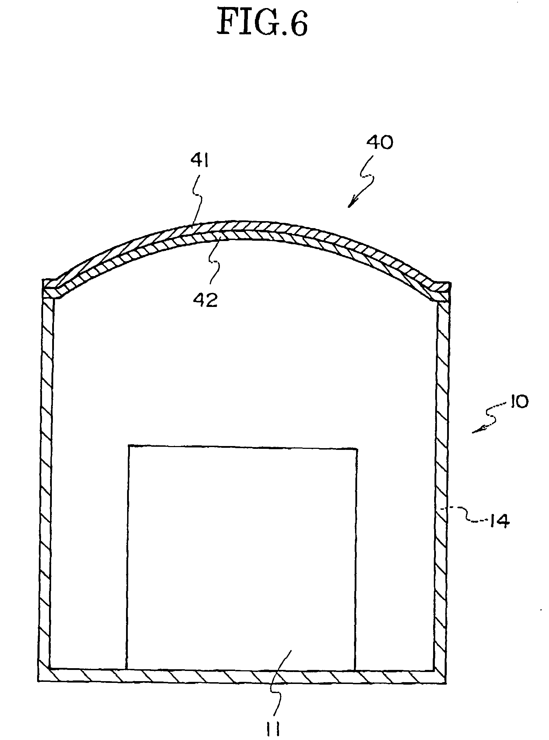

Fig. 6 is a schematic elevational sectional view showing the second embodiment of the outdoor-installed housing according to the present invention in a state when normal temperature prevails around the multiple-layer wall.

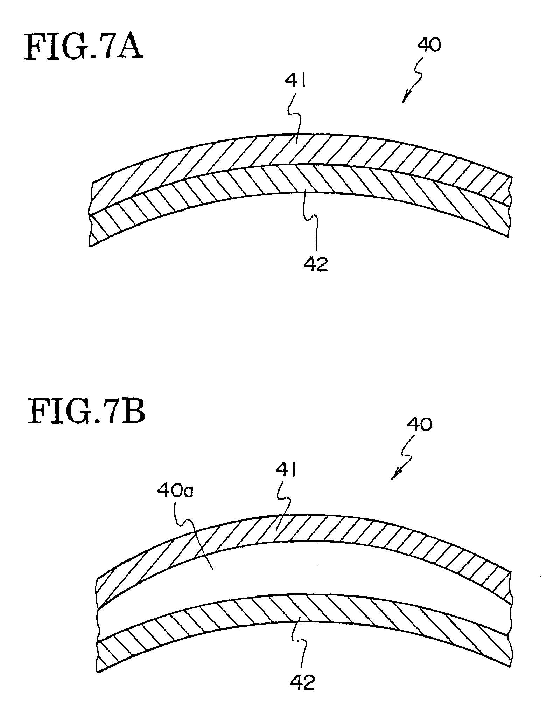

Figs. 7A and 7B are fragmentary enlarged-scale sectional views showing the second embodiment of the outdoor-installed housing shown in Fig. 6 according to the present invention, Fig. 6A showing the housing with normal temperature prevailing around the multiple-layer wall, and Fig. 6B showing the housing with an increased temperature prevailing.

This embodiment of the outdoor-installed housing as illustrated is a modification of the previous first embodiment, and it is adapted that an inner space is formed in a multiple-layer wall, which comprises two sheet-like members having different linear expansion coefficients, when the temperature around the multiple-layer wall is increased. For the remainder, this embodiment is substantially the same as the previous first embodiment. Thus, parts like those in the first embodiment are designated by like reference numerals and symbols, and are not described in detail.

As shown in Fig. 6, this embodiment of the outdoor-installed housing 10, which accommodates an apparatus 11 inside it, has as its top wall (or ceiling) a multiple-layer wall 40 comprising an outer and an inner wall 41 and 42. When the temperature of the multiple-layer wall 40 is increased with an ambient temperature change, the outer wall 41 undergoes linear expansion to form an inner space 40a between it and the inner wall 42. The outer and inner walls 41 and 42 of the multiple-layer wall 40 in this embodiment are sheet-like members having different linear expansion coefficients. The outer wall 41 has a greater linear expansion coefficient than the inner wall 42.

As shown in Fig. 6, at normal temperature the outer and inner walls 41 and 42 protrude upwardly of the housing in close contact with each other, and in this state their edges are secured to heat-insulating walls 14 constituting other walls of the housing 10. When the temperature of the outside of the housing 10 is increased, the outer wall 41 undergoes linear expansion from the state as shown in Fig. 7A to the state as shown in Fig. 7B, thus forming an inner space 40a between it and The inner wall 42.

With the provision of the multiple-layer wall 40, which comprises the outer wall 41 formed from a member having a large linear expansion coefficient and the inner wall 42 formed from a member having a small liner expansion coefficient, as the top wall of the housing 10 to receive sunlight when the housing 10 is installed outdoors, with a temperature rise of the multiple-layer wall 40 caused by sunlight reception, the outer wall 42 undergoes linear expansion to further protrude to the outside of the housing as shown in Fig. 7B, thus forming the inner space 40a between it and the inner wall] 42. Consequently, the factor of heat penetration from the top of the housing 10 is reduced, thus suppressing the temperature increase inside the housing due to exposure to sunlight.

As shown above, in the embodiment of the outdoor-installed housing the multiple-layer wall 40 which is provided at a portion of the walls of the housing 10, forms the inner space 40a in it in accordance with the ambient temperature increase, thus reducing the factor of heat penetration into the housing 10. Thus, while permitting heat penetration into and out of the housing to be obtained efficiently at normal temperature, with a sudden increase in the temperature outside the housing 10 the heat penetration factor can be reduced to suppress a sudden temperature rise of the apparatus 11 accommodated in the housing 10 and also the housing 10 itself.

This embodiment thus permits effective prevention of a trouble in or damage to the apparatus inside the housing 10 due to excessive heating. Also, no temperature control means or the like is necessary, and like the first embodiment it is possible to reduce the size and weight of the housing.

As has been described in the foregoing, with the outdoor-installed housing according to the present invention at least a portion of the housing walls is constituted by a multiple-layer wall, which comprises two or more sheet-like members normally held in close contact with one another and capable of undergoing linear expansion or contraction in accordance with ambient temperature changes. An inner space or inner spaces thus can be formed in the multiple-layer wall in accordance with an ambient temperature change, thus changing the factor of heat penetration into and out of the housing. Thus, while ensuring heat penetration into and out of the housing, it is possible to prevent occurrence of condensation on the housing inner wall surfaces and also suppress excessive temperature increase inside the housing.

Especially, the present invention is applicable to any housing capable of protection of the apparatus accommodated therein due to the ambient temperature changes.

Changes in construction will occur to Those skilled in the art and various apparently different modifications and embodiments may be made without departing from the scope of the present invention. The matter set forth in the foregoing description and accompanying drawings is offered by way of illustration only. It is therefore intended that the foregoing description be regarded as illustrative rather than limiting.

## Claims

1. An outdoor-installed housing which is hollow, capable of accommodating an apparatus in its inside and installed outdoors, and in which:
at least a portion of its walls is constituted by a multiple-layer wall comprising two or more sheet-like members normally in close planar contact with one another; and
in accordance with an ambient temperature change an inner space or inner spaces is formed between adjacent ones of the two or more sheet-like members of the multiple-layer wall, thus changing the factor of heat penetration through the multiple-layer wall.

2. An outdoor-installed housing which is hollow, capable of accommodating an apparatus in its inside and installed outdoors, and in which:
at least a portion of its walls is constituted by a multiple-layer wall comprising two or more sheet-like members having different linear expansion coefficients and provided in close planar contact with one another; and
in accordance with an ambient temperature change an inner space or inner spaces is formed between adjacent ones of the two or more sheet-like members of the multiple-layer wall, thus changing the factor of heat penetration through the multiple-layer wall.

3. The outdoor-installed housing according to claim 1 or 2, wherein when the temperature of the multiple-layer wall is reduced to be lower than the condensation point with a change in temperature around the multiple-layer wall, at least one of the two or more sheet-like members undergoes contraction to form an inner space adjacent to it.

4. The outdoor-installed housing according to claim 1 or 2, wherein when the temperature of the multiple-layer wall is increased in accordance with a change in temperature around the multiple-layer wall, at least one of the two or more sheet-like members undergoes expansion to form an inner space adjacent to it.

5. The outdoor-installed housing according to claim 1 or 2, wherein at least a portion of the walls of the housing excluding the multiple-layer wall is constituted by a heat-insulating wall.

6. The outdoor-installed housing according to claim 1 or 2, wherein at least a portion of the walls of the housing excluding the multiple-layer wall is constituted by a heat radiator of an apparatus accommodated in the housing.

7. A housing having hollow portion in which an apparatus is accommodated wherein a multiple-layer wall is provided at a portion of the housing, the multiple-layer wall including two or more sheet-like members having different linear expansion coefficients and provided in close planar contact with one another such that in accordance with an ambient temperature change an inner space or inner spaces is formed between adjacent ones of the two or more sheet-like members of the multiple-layer wall.

8. The housing according to claim 7, wherein two of the sheet-like members are provided.

9. The housing according to claim 7, wherein three of the sheet-like members are provided.

10. The housing according to claim 7, wherein at least a portion of the walls of the housing excluding the multiple-layer wall is constituted by a heat-insulating wall.

11. The housing according to claim 7, wherein at least a portion of the walls of the housing excluding the multiple-layer wall is constituted by a heat radiator of the apparatus accommodated in the housing.

12. The housing according to claim 7, wherein the multiple-layer wall is provided on a side portion receiving sunlight of the housing.

13. The housing according to claim 7, wherein the formed inner space or inner spaces communicate with the inside of the housing.
